# FASCICULE DE BREVET EUROPEEN

(11) **EP 1 058 302 B1**
(45) Date de publication et mention de la délivrance du brevet: **25.07.2007**
(21) Numéro de dépôt: 00410055.8
(22) Date de dépôt: 30.05.2000
(51) Int. Cl.: H01L 21/331, H01L 29/737, H01L 29/73

(54) **Procédé de fabrication de dispositifs bipolaires à jonction base-émetteur autoalignée**
Verfahren zur Herstellung von bipolaren Bauelementen mit selbstausrichtetem Basis-Emitter Übergang
Method of manufacturing bipolar devices having self-aligned base-emitter junction

(30) Priorité: 31.05.1999 FR 9907023
(43) Date de publication de la demande: 06.12.2000
(73) Titulaire: STMicroelectronics S.A., 92120 Montrouge (FR)
(72) Inventeur: Gris, Yvon, 38210 Tullins (FR)
(74) Mandataire: de Beaumont, Michel

(56) Documents cités:
- EP-A- 0 418 185
- US-A- 5 137 840
- RISEMAN J: "SELF-ALIGNED EPITAXIAL BASE TRANSISTOR" IBM TECHNICAL DISCLOSURE BULLETIN,US,IBM CORP. NEW YORK, vol. 26, no. 7A, décembre 1983 (1983-12), pages 3190-3191, XP000806629 ISSN: 0018-8689

## Description

La présente invention concerne, de façon générale, la fabrication de dispositifs bipolaires. Elle s'applique à la fabrication de transistors bipolaires en technologie bipolaire pure ou en technologie mixte bipolaire - MOS (BICMOS).

La fabrication des jonctions base-émetteur des transistors bipolaires pose différents problèmes. Il est en particulier souhaitable de disposer de procédés de fabrication autoalignés pour réduire les dimensions des dispositifs.

Il est également souhaitable de ne pas implanter la base ce qui crée inévitablement des profils de dopage gaussiens. L'idéal est de réaliser la base par un dépôt épitaxial dopé.

Le document US-A-5 137 840 décrit un procédé de fabrication d'un transistor bipolaire à base épitaxiale dans lequel le substrat est préalablement gravé.

Il est également souhaitable de minimiser la résistance d'accès à la base (résistance de base) et d'améliorer la réponse en fréquence des transistors. Pour ce faire, on a notamment proposé d'utiliser comme base une couche de silicium-germanium. Toutefois, l'utilisation du germanium, bien qu'améliorant considérablement la résistance d'accès d'un transistor bipolaire et le temps de transit dans la base, pose des problèmes de mise en oeuvre. Il est difficile d'apporter ce germanium par une implantation dans une couche de silicium, et une telle couche ne supporte pas d'être soumise à de hautes températures.

Un objet de la présente invention est donc de proposer un nouveau procédé de fabrication de transistors bipolaires permettant de réaliser des jonctions base-émetteur de façon auto-alignée.

Un autre objet de la présente invention est de proposer un tel procédé permettant de minimiser la résistance de base des transistors.

Un autre objet de la présente invention est de proposer un tel procédé compatible avec l'utilisation d'une région de base en silicium-germanium.

Pour atteindre ces objets, la présente invention prévoit un procédé de fabrication de la jonction émetteur-base d'un transistor bipolaire sur une région active de silicium d'un premier type de conductivité délimitée par une tranchée remplie d'un matériau d'isolement de champ, l'ensemble étant recouvert d'une première couche isolante. Ce procédé comprend les étapes consistant à graver la première couche isolante de façon à découvrir la surface de la région active ; graver la surface de la région active sur une hauteur donnée ; former des premier et deuxième espaceurs en silicium très fortement dopé du deuxième type de conductivité à la périphérie interne des reliefs abrupts résultant respectivement de la gravure de la première couche isolante et de la gravure de la région active ; déposer par épitaxie une couche de base dopée du deuxième type de conductivité ; former un troisième espaceur en un matériau isolant à la périphérie interne d'un relief de la couche de base correspondant au premier espaceur; déposer une couche d'émetteur de silicium fortement dopé du premier type de conductivité; et effectuer un polissage mécano-chimique, en utilisant la première couche et le troisième espaceur comme points d'arrêt.

Selon un mode de réalisation de la présente invention, le procédé comprend, pour la gravure de la région active, les étapes de dépôt d'une couche de silicium d'une épaisseur prédéterminée sur la première couche isolante ;de masquage et d'élimination de ladite couche de silicium et de la première couche isolante au dessus de la zone active ; et de gravure sélective du silicium avec détection et arrêt de gravure quand on atteint la première couche isolante.

Selon un mode de réalisation de la présente invention, la formation des premier et deuxième espaceurs est suivie d'une surgravure de la région active.

Selon un mode de réalisation de la présente invention, la première couche isolante est un multicouche constitué d'une couche d'oxyde de silicium et d'une couche de nitrure de silicium.

Selon un mode de réalisation de la présente invention, les premier et deuxième espaceurs sont en silicium polycristallin dopé du deuxième type de conductivité.

Selon un mode de réalisation de la présente invention, au moins le premier espaceur est en silicium monocristallin.

Selon un mode de réalisation de la présente invention, la couche de base est constituée de silicium et de germanium.

Selon un mode de réalisation de la présente invention, le gradient de germanium et le gradient de dopant du premier type de conductivité dans la couche de base sont tels que la concentration maximale de germanium et la concentration maximale du dopant sont à proximité respectivement de l'interface avec la région active et de l'interface avec la couche d'émetteur.

Selon un mode de réalisation de la présente invention, le troisième espaceur est en oxyde de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

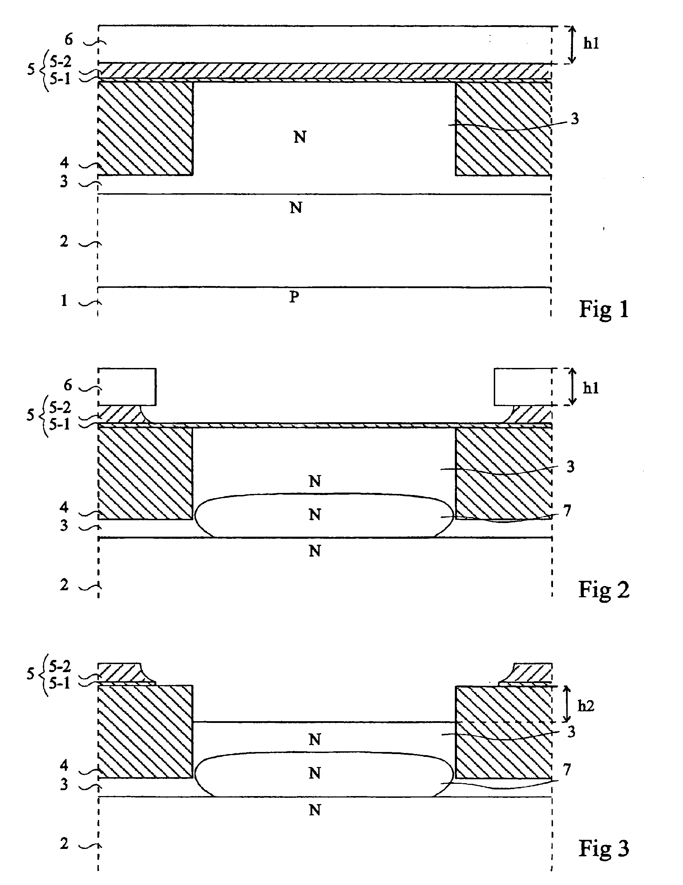

les figures 1 à 9 sont des vues en coupe partielles et schématiques d'un transistor bipolaire à différentes étapes d'un exemple de mise en oeuvre d'un procédé de fabrication selon un mode de réalisation de la présente invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

La figure 1 représente l'état d'un substrat de silicium 1 d'un premier type de conductivité, par exemple de type P, après des étapes initiales d'un procédé selon un mode de réalisation de la présente invention. Le substrat comprend du côté de sa face supérieure des régions 2 et 3 du deuxième type de conductivité, par exemple N, respectivement fortement et faiblement dopées. La région 2 résulte par exemple d'une implantation/diffusion dans le substrat 1, et la région 3 d'une croissance épitaxiale. Des tranchées remplies d'un matériau d'isolement de champ 4, par exemple de l'oxyde de silicium (SiO₂), délimitent dans la région 3 des zones actives. L'ensemble est recouvert d'une couche isolante 5. La couche 5 est recouverte d'une couche 6 de silicium, de préférence polycristallin. L'épaisseur h1 de la couche 6 est choisie de la façon qui sera expliquée ci-après.

Selon un mode de réalisation de la présente invention, la couche 5 est un multicouche constitué de couches de matériaux isolants distincts gravables sélectivement les uns par rapport aux autres et par rapport au silicium. Il s'agira par exemple d'une couche inférieure 5-1 d'oxyde de silicium et d'une couche supérieure 5-2 de nitrure de silicium (Si₃N₄).

Aux étapes suivantes dont le résultat est illustré en figure 2, on ouvre les couches 6 et 5 grâce à l'unique masque utilisé dans ce processus de façon à découvrir la surface active de la région 3 dans laquelle doit être formé un transistor bipolaire, en débordant sur la région d'isolement de champ périphérique. Après formation de l'ouverture, on effectue éventuellement une implantation à haute énergie pour former au fond de la région 3, en contact avec la région 2, une région 7 fortement dopée de type N destinée à constituer le fond du collecteur du transistor bipolaire. Pour l'implantation de la région 7, on maintient de préférence la couche isolante 5-1. On pourra également éliminer la couche 5-1 puis faire croître un oxyde thermique. La formation d'un contact ohmique avec la région 2 se fait de façon classique et n'est pas décrite ni représentée ici.

Aux étapes suivantes dont le résultat est illustré en figure 3, on élimine la couche 5-1 d'oxyde de silicium. Ensuite, on effectue une gravure anisotrope du silicium. Alors, la surface découverte de la région 3 au fond de l'ouverture est gravée en même temps que la couche 6. La gravure est arrêtée dès que la couche 6 est complètement éliminée.

Un avantage de graver la couche 6 en même temps que la surface de la région 3 est de disposer d'une couche d'arrêt de gravure constituée par la couche isolante 5, ce qui fournit également une détection de fin d'attaque. Les différences de propriétés de gravure des matériaux constituant les couches 6 et 3 étant connues, l'épaisseur h1 de la couche 6 permet de définir la hauteur h2 de la région 3 que l'on désire éliminer.

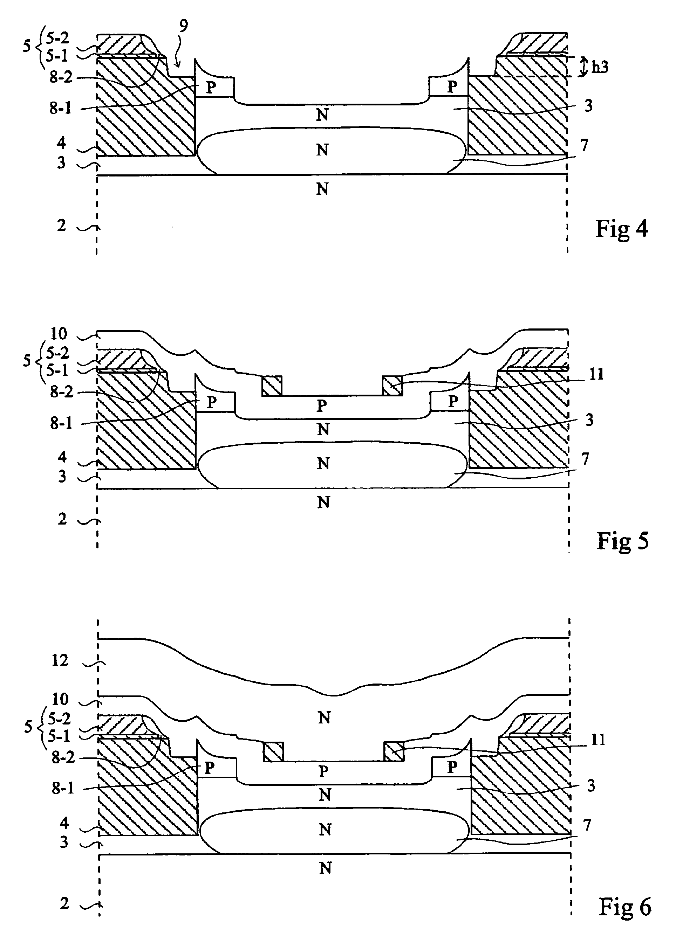

Aux étapes suivantes dont le résultat est illustré en figure 4, on dépose une couche de silicium très fortement dopée de type P. Le dopage est de préférence effectué in situ. Ensuite, la couche très fortement dopée est gravée de façon anisotrope pour ne laisser en place que des portions 8-1 et 8-2 formant espaceurs le long des reliefs abrupts que constituent respectivement le matériau d'isolement de champ 4 et la couche isolante 5. La largeur de la portion 8-1 est fixée par l'épaisseur initiale de la couche de silicium 6.

On notera que la formation des portions 8-1 et 8-2 s'accompagne d'une surgravure volontaire de la région 3 de la couche épitaxiale. Cette surgravure est effectuée sur une épaisseur suffisamment importante pour éliminer un éventuel dopage parasite provenant de la diffusion des dopants de la portion 8-1 à la surface de la région 3, avant et éventuellement après la gravure de la couche fortement dopée. La surgravure de la région 3 est de préférence effectuée de façon à obtenir une pente douce entre la surface découverte de la région 3 et son point de contact avec la portion 8-1.

Ensuite, on grave le matériau d'isolement de champ 4 sur une hauteur h3 inférieure à la hauteur maximale de la portion 8-1. Cette gravure a pour objet de former un évidement 9 à la périphérie externe de la portion 8-1. La portion 8-1 se retrouve donc partiellement en surélévation par rapport au matériau d'isolement de champ 4 qui l'entoure.

Aux étapes suivantes dont le résultat est illustré en figure 5, on dépose de façon conforme une couche 10 de silicium sur une épaisseur au moins égale à la hauteur h3 de l'évidement 9 (figure 4). La couche 10 est destinée à constituer la base du transistor bipolaire et est déposée par épitaxie de façon à être monocristalline au moins au-dessus de la région 3. La couche 10 est faiblement dopée à l'aide d'un dopant de type P, par exemple du bore à une concentration de l'ordre de 5x10¹⁸ atomes/cm³.

Le dépôt de la couche de silicium 10 ayant été effectué de façon conforme, la face supérieure de cette couche reproduit le relief des couches sous-jacentes et notamment les flancs intérieurs relativement abrupts de la couronne de silicium 8-1. On peut donc former, de la façon représentée, un espaceur annulaire 11, par dépôt puis gravure anisotrope d'une couche isolante, par exemple en oxyde de silicium.

À l'étape suivante dont le résultat est illustré en figure 6, on dépose une couche 12 de silicium polycristallin fortement, de préférence dopée in situ à l'aide d'un dopant de type N. Le dopant sera un quelconque dopant connu, par exemple de l'arsenic ou du phosphore. La couche 12 est destinée à constituer l'émetteur du transistor bipolaire.

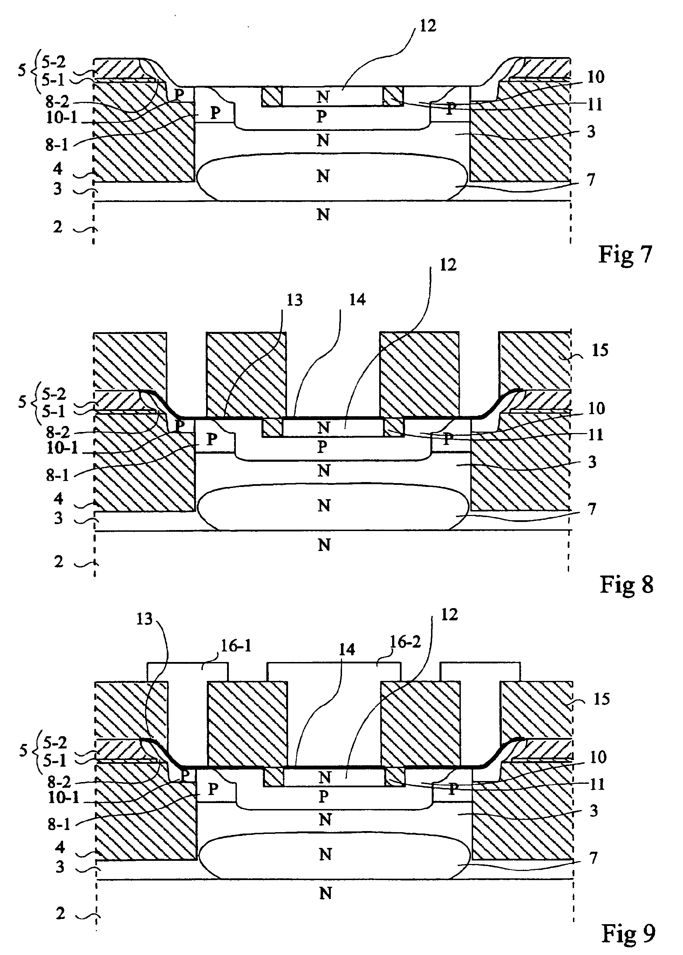

À l'étape suivante dont le résultat est illustré en figure 7, on effectue selon la présente invention un polissage mécano-chimique. Ce polissage s'arrête quand on atteint les faces supérieures de la couche 5 et de l'espaceur 11. La planéité obtenue est d'autant meilleure que les dimensions, au moins dans une direction, sont faibles, et c'est toujours le cas des dispositifs intégrés haute fréquence. Il ne subsiste alors de la couche 12 de silicium de type N qu'une partie d'émetteur interne à l'espaceur annulaire 11. La couche de silicium de type P reste en place dans une partie centrale de base. Il demeure également une partie périphérique 10-1 de la couche 10 qui assure un contact entre les portions 8-1 et 8-2 de silicium fortement dopé de type P (dans la région correspondant à l'évidement 9 de la figure 4). On notera qu'il existe une continuité électrique entre les éléments 10, 8-1, 10-1 et 8-2.

Aux étapes suivantes dont le résultat est illustré en figure 8, on effectue une siliciuration des surfaces conductrices apparentes. Il se forme ainsi un premier contact siliciuré de base 13 sur les surfaces supérieures des divers éléments de même premier type de dopage (P) 10, 8-1, 10-1 et 8-2. Une partie importante du contact siliciuré 13 se trouve être au-dessus de la région isolante 4. La capacité base-collecteur est donc réduite. Il se forme également sur la couche d'émetteur 12 un deuxième contact siliciuré 14. Ensuite, on dépose et on ouvre une couche isolante 15, par exemple en oxyde de silicium, de façon à découvrir partiellement les contacts 13 et 14. On notera que, en raison de l'extension du contact de base, due à la présence de siliciure 13 sur les régions 8-1, 10-1 et 8-2, le positionnement de l'ouverture de contact de base n'est pas critique, ce qui constitue un avantage notable de l'invention.

Le procédé s'achève, comme l'illustre la figure 9, par le remplissage des ouvertures de la couche 15 par un matériau conducteur 16, par exemple métallique, de préférence du tungstène. On forme ainsi des prises de contact de base et d'émetteur 16-1 et 16-2, respectivement.

Dans une étape ultérieure du procédé (non représentée) on formera également une reprise de contact avec la couche 2 de façon à former une prise de contact du collecteur 7, en dehors du plan représenté.

La présente invention s'applique tout particulièrement à la formation de transistors dont la base est en silicium-germanium. En effet, lors de l'étape de dépôt épitaxial de la couche de base 10 décrite précédemment en relation avec la figure 5, il est possible de prévoir qu'une partie au moins de l'épaisseur de la couche 10 soit en alliage germanium silicium, selon un profil de concentration choisi. Les profils de concentration du germanium et du dopant, par exemple du bore, inséré dans la couche 10 sont de préférence tels que leurs pics de concentration maximale à l'intérieur de la couche 10 soient distincts et que celui de germanium soit plus proche de la jonction substrat-base 3-10 que celui du bore.

Un avantage du procédé selon la présente invention est de permettre la prise de contact de base sur un élément de silicium très fortement dopé plus facile à siliciurer qu'une couche comportant du germanium (couche 10). On notera que, le dopage des portions 8-1 et 8-2 étant très élevé, il se produit une diffusion importante dans les éléments voisins, et notamment dans la partie 10-1 assurant un contact entre elles.

Dans un mode de réalisation de la présente invention les caractéristiques des diverses couches et gravures seront les suivantes :
- région 2 :
   épaisseur : de 1 à 3 µm, de préférence 2 µm ;
   dopage : 2x10¹⁹ at./cm³ d'arsenic ;
- région 3 (formée par épitaxie) :
   épaisseur : de 0,5 à 1 µm ;
   dopage : 1x10¹⁶ at./cm³ d'arsenic ;
- multicouche 5 :
   couche 5-1 en oxyde de silicium, d'une épaisseur de 2 à 20 nm, de préférence de l'ordre de 5 nm ;
   couche 5-2 en nitrure de silicium, d'une épaisseur de 40 à 100 nm, de préférence de l'ordre de 55 nm ;
- épaisseur h1 (figures 1 et 2) de la couche 6 de définition de l'arrêt de gravure de la région 3 : de 100 à 250 nm, de préférence de l'ordre de 150 nm;
- hauteur h2 de gravure de la région 3 (figure 3) : du même ordre que l'épaisseur h1 ;
- portions 8-1 et 8-2 : dopage 1x10²⁰ at./cm³ de bore
- surgravure de la surface de la région 3 (figure 4) : sensiblement égale à la hauteur h1;
- hauteur h3 de l'évidement 9 (figure 4) : : comprise entre 30 et 100 nm, de préférence de l'ordre de 60 nm;
- couche de base 10 de germanium-silicium : épaisseur comprise entre 30 et 150 nm, de préférence de l'ordre de 60 nm (épaisseur plus élevée en présence de Ge) ;
- couche d'émetteur 12 de silicium polycristallin : dopage : 10²⁰ à 2x10²¹ at./cm³ d'arsenic ou de phosphore ; épaisseur dans la fenêtre active avant polissage (figure 6) : de 100 à 250 nm, de préférence de l'ordre de 150 nm; épaisseur dans la fenêtre active après polissage (figure 7) : de 80 à 200 nm, de préférence de l'ordre de 100 nm ;
- couche 15 en oxyde de silicium, d'une épaisseur comprise entre 300 et 2000 nm, de préférence de l'ordre de 800 nm ; et
- matériau de contact-métallisation 16-1, 16-2 : tungstène ou aluminium ou alliage de ces métaux avec couche barrière de Ti/TiN entre métal et siliciure ; les métallisations s'appuyant sur la couche 15 peuvent être en un matériau distinct d'un matériau de remplissage des ouvertures de cette même couche 15.

Bien entendu, la présente invention est susceptible de diverses variantes et modifications qui apparaîtront à l'homme de l'art. En particulier, on a décrit et illustré précédemment les principes de l'invention appliqués à la formation d'un transistor bipolaire de type NPN. Toutefois, l'homme de l'art comprendra que l'on pourrait former selon les mêmes principes un transistor bipolaire de type PNP à condition de doper de façon complémentaire les différentes parties, couches ou portions en silicium 1, 2, 3, 7, 8-1, 8-2, 10 et 12.

## Revendications

1. Procédé de fabrication de la jonction émetteur-base d'un transistor bipolaire sur une région active (3) de silicium d'un premier type de conductivité délimitée par une tranchée remplie d'un matériau d'isolement de champ (4), l'ensemble étant recouvert d'une première couche isolante (5), **caractérisé en ce qu'**il comprend les étapes suivantes :
graver la première couche isolante (5), de façon à découvrir la surface de la région active ;
graver la surface de la région active sur une hauteur donnée (h2);
former des premier et deuxième espaceurs (8-1, 8-2) en silicium très fortement dopé du deuxième type de conductivité, à la périphérie interne des reliefs abrupts résultant respectivement de la gravure de la première couche isolante et de la gravure de la région active ;
déposer par épitaxie une couche de base (10) dopée du deuxième type de conductivité;
former un troisième espaceur (11) en un matériau isolant à la périphérie interne d'un relief de la couche de base correspondant au premier espaceur ;
déposer une couche d'émetteur (12) de silicium fortement dopé du premier type de conductivité ; et
effectuer un polissage mécano-chimique, en utilisant la première couche et le troisième espaceur comme points d'arrêt.

2. Procédé selon la revendication 1, **caractérisé en ce qu'**il comprend, pour la gravure de la région active (3), les étapes suivantes :
dépôt d'une couche de silicium (6) d'une épaisseur prédéterminée (h1) sur la première couche isolante (5) ;
masquage et élimination de ladite couche de silicium et de la première couche isolante au dessus de la zone active ; et
gravure sélective du silicium avec détection et arrêt de gravure quand on atteint la première couche isolante (5).

3. Procédé selon la revendication 1 ou 2, **caractérisé en ce que** la formation des premier et deuxième espaceurs (8-1, 8-2) est suivie d'une surgravure de la région active (3).

4. Procédé selon la revendication 1 ou 2, **caractérisé en ce que** la première couche isolante (5) est un multicouche constitué d'une couche d'oxyde de silicium (5-1) et d'une couche de nitrure de silicium (5-2).

5. Procédé selon la revendication 1 ou 2, **caractérisé en ce que** les premier et deuxième espaceurs (8-1, 8-2) sont en silicium polycristallin dopé du deuxième type de conductivité.

6. Procédé selon la revendication 1 ou 2, **caractérisé en ce que** au moins le premier espaceur (8-1) est en silicium monocristallin.

7. Procédé selon la revendication 1 ou 2, **caractérisé en ce que** la couche de base (10) est constituée de silicium et de germanium.

8. Procédé selon la revendication 7, **caractérisé en ce que** le gradient de germanium et le gradient de dopant du premier type de conductivité dans la couche de base (10) sont tels que la concentration maximale de germanium et la concentration maximale du dopant sont à proximité respectivement de l'interface avec la région active (3) et de l'interface avec la couche d'émetteur (12).

9. Procédé selon la revendication 1, **caractérisé en ce que** le troisième espaceur (11) est en oxyde de silicium.

## Claims

1. A method for manufacturing the emitter-base junction of a bipolar transistor on an active silicon region (3) of a first conductivity type delimited by a trench filled with a field insulation material (4), the assembly being covered with a first insulating layer (5), **characterized in that** it includes the steps of:
etching the first insulating layer (5) to expose the surface of the active region;
etching the surface of the active region down to a given height (h2);
forming first and second very heavily-doped silicon spacers (8-1, 8-2) of the second conductivity type at the internal periphery of the abrupt protrusions respectively resulting from the etching of the first insulating layer and from the etching of the active region;
growing by epitaxy a doped base layer (10) of the second conductivity type;
forming a third spacer (11) in an insulating material at the internal periphery of a protrusion of the base layer corresponding to the first spacer;
depositing a heavily-doped silicon emitter layer (12) of the first conductivity type; and
performing a chem-mech polishing, by using the first layer and the third spacer as stops.

2. The method of claim 1, **characterized in that** it includes, for the etching of the active region (3), the steps of:
depositing a silicon layer (6) of a predetermined thickness (h1) on the first insulating layer (5);
masking and removing the silicon layer and the first insulating layer above the active area; and
selectively etching the silicon with detection and etch stop when the first insulating layer (5) is reached.

3. The method of claim 1 or 2, **characterized in that** forming of the first and second spacers (8-1, 8-2) is followed by an overetching of the active region (3).

4. The method of claim 1 or 2, **characterized in that** the first insulating layer (5) is a multilayer formed of a silicon oxide layer (5-1) and of a silicon nitride layer (5-2).

5. The method of claim 1 or 2, **characterized in that** the first and second spacers (8-1, 8-2) are made of doped polysilicon of the second conductivity type.

6. The method of claim 1 or 2, **characterized in that** at least the first spacer (8-1) is made of single-crystal silicon.

7. The method of claim 1 or 2, **characterized in that** the base layer (10) is formed of silicon and germanium.

8. The method of claim 7, **characterized in that** the germanium gradient and the gradient of dopant of the first conductivity type in the base layer (10) are such that the maximum germanium concentration and the maximum dopant concentration are respectively close to the interface with the active region (3) and to the interface with the emitter region (12).

9. The method of claim 1, **characterized in that** the third spacer (11) is made of silicon oxide.

## Patentansprüche

1. Verfahren zur Herstellung einer Emitter-Basis-Grenzschicht (bzw. Junction) eines Bipolartransistors auf einem aktiven Siliziumbereich (3) eines ersten Leitfähigkeitstyps, begrenzt durch einen mit einem Feldisolationsmaterial (4) gefüllten Graben, wobei die Anordnung mit einer ersten Isolierschicht (5) überzogen ist, **dadurch gekennzeichnet, dass** die folgenden Schritte vorgesehen sind:
Ätzen der ersten Isolierschicht (5) um die Oberfläche des aktiven Bereichs freizulegen;
Ätzen der Oberfläche des aktiven Bereichs hinab auf eine gegebene Höhe (h2);
Ausbilden erster und zweiter sehr stark dotierter Silizium-Abstandsmittel (8-1, 8-2) des zweiten Leitfähigkeitstyps am Innenumfang der abrupten Vorsprünge, die sich als Resultat des Ätzens der ersten Isolierschicht bzw. aus dem Ätzen des aktiven Bereichs ergeben;
Aufwachsen einer dotierten Basisschicht (10) des zweiten Leitfähigkeitstyps durch Epitaxie;
Ausbilden dritter Abstandsmittel (11) in einem Isoliermaterial am Innenumfang eines Vorsprungs der Basisschicht, entsprechend den ersten Abstandsmitteln;
Abscheiden einer stark dotierten Silizium-Emitterschicht (12) des ersten Leitfähigkeitstyps; und
Ausführen einer chemisch-mechanischen Polierung, unter Verwendung der ersten Schicht und der dritten Abstandsmittel als Stoppmittel.

2. Verfahren nach Anspruch 1, **dadurch gekennzeichnet, dass** zum Ätzen des aktiven Bereichs (3) die folgenden Schritte vorgesehen sind:
Abscheiden einer Siliziumschicht (6) mit einer vorbestimmten Dicke (h1) auf der ersten Isolierschicht (5);
Maskieren und Entfernen der Siliziumschicht und der ersten Isolierschicht oberhalb der aktiven Fläche; und
selektives Ätzen des Siliziums mit Detektions- und Ätzstopp, wenn die erste Isolierschicht (5) erreicht ist.

3. Verfahren nach Anspruch 1 oder 2, **dadurch gekennzeichnet, dass** die ersten und zweiten Abstandsmittel (8-1, 8-2) gefolgt werden von einer Überätzung des aktiven Bereichs (3).

4. Verfahren nach Anspruch 1 oder 2, **dadurch gekennzeichnet, dass** die erste Isolierschicht (5) eine Mehrfachschicht ist, und zwar gebildet aus einer Silizium-Oxidschicht (5-1) und einer Silizium-Nitridschicht (5-2).

5. Verfahren nach Anspruch 1 oder 2, **dadurch gekennzeichnet, dass** die ersten und zweiten Abstandsmittel (8-1, 8-2) aus dotiertem Polysilizium des zweiten Leitfähigkeitstyps hergestellt sind.

6. Verfahren nach Anspruch 1 oder 2, **dadurch gekennzeichnet, dass** mindestens das erste Abstandsmittel (8-1) aus Einkristall-Silizium hergestellt ist.

7. Verfahren nach Anspruch 1 oder 2, **dadurch gekennzeichnet, dass** die Basisschicht (10) aus Silizium und Germanium gebildet ist.

8. Verfahren nach Anspruch 7, **dadurch gekennzeichnet, dass** der Germanium-Gradient und der Gradient des Dotiermittels des ersten Leitfähigkeitstyps in der Basisschicht (10) derart vorgesehen sind, dass die maximale Germanium-Konzentration und die maximale Dotiermittel-Konzentration jeweils dicht zur Grenzschicht (Interface) mit der aktiven Region (3) bzw. der Grenzschicht (Interface) mit dem Emitterbereich (12) sind.

9. Verfahren nach Anspruch 1, **dadurch gekennzeichnet, dass** die dritten Abstandsmittel (11) aus Siliziumoxid hergestellt sind.
